(19) Europäisches Patentamt
European Patent Office
Office européen des brevets

(11) EP 1 830 430 A1

(12) # EUROPEAN PATENT APPLICATION
published in accordance with Art. 158(3) EPC

(43) Date of publication:
**05.09.2007 Bulletin 2007/36**

(21) Application number: **05782385.8**

(22) Date of filing: **12.09.2005**

(51) Int Cl.:
***H01M 14/00*** *(2006.01)* ***C01G 23/07*** *(2006.01)*
***H01L 31/04*** *(2006.01)*

(86) International application number:
**PCT/JP2005/016733**

(87) International publication number:
**WO 2006/067897 (29.06.2006 Gazette 2006/26)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.12.2004 JP 2004368989**

(71) Applicant: **Nippon Aerosil Co., Ltd.**
**Shinjuku-ku,**
**Tokyo 160-0913 (JP)**

(72) Inventors:
- **UCHIDA, Satoshi**
  **Sendai-shi, Miyagi 9820807 (JP)**
- **SANEHIRA, Yoshitaka**
  **Sendai-shi, Miyagi 9820801 (JP)**
- **BRANDL, Paul**
  **c/o NIPPON AEROSIL CO., LTD.**
  **Yokkaichi-shi, Mie 5100841 (JP)**
- **OCHIAI, Mitsuru**
  **c/o NIPPON AEROSIL CO., LTD.**
  **Tokyo 1630913 (JP)**
- **SCHUMACHER, Kai**
  **65719 Hofheim (DE)**
- **SUZUKI, Shigeru**
  **c/o NIPPON AEROSIL CO., LTD.**
  **Yokkaichi-shi, Mie 5100841 (JP)**

(74) Representative: **Leman Consulting S.A.**
**Chemin de Précossy 31**
**CH-1260 Nyon (CH)**

(54) **PHOTOELECTRIC TRANSDUCER, PROCESS FOR PRODUCING TITANIUM OXIDE PARTICLE FOR USE IN THE SAME, AND DYE-SENSITIZED SOLAR CELL UTILIZING THE PHOTOELECTRIC TRANSDUCER**

(57) The present invention aims to improve short circuit current density and photo-to-electron conversion efficiency without thickening the whole thickness of the device and increasing the number of manufacturing processes. A photovoltaic device comprises a light-transmittable base material 31, and a porous film 41 b formed on the base material and adsorbing a dye. The porous film 41b adsorbing the dye 41d contains a titanium dioxide particle 41c containing aluminum oxide. The titanium dioxide particle 41c is a mixed particle of a first titanium dioxide particle doped with aluminum oxide and a second titanium dioxide particle not doped with aluminum oxide. The first titanium dioxide particle contains 70 to 95 wt.% anatase crystal, and a specific surface area by the BET method of the titanium dioxide particle 41c is 35 to 65 $m^2/g$, and an adsorbing amount of oil of the titanium dioxide particle 41c measured by the method based on JIS K5101 is 55 to 75 ml/100g.

Fig.1

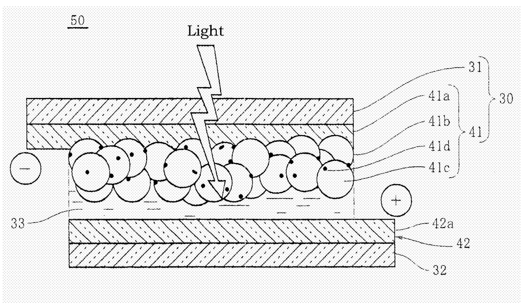


30: Photovoltaic device
31: First base material (base material)
41a: First conductive film
41b: Porous film
41c: Titanium dioxide particle
41d: Dye
50: Dye-sensitized solar cell



Printed by Jouve, 75001 PARIS (FR)

## Description

### TECHINICAL FIELD

The present invention relates to a photovoltaic device, a manufacturing method of a titanium dioxide particle used for making the photovoltaic device, and a dye-sensitized solar cell using the photovoltaic device. In this photovoltaic device, the titanium dioxide particle is dispersed in an electrically-conductive film.

### BACKGROUND ART

In recent years, the dye-sensitized solar cell is noticed as a solar cell having a low cost. This dye-sensitized solar cell has an electrochemical cell structure passing through an iodine solution without using a silicon semiconductor. As a material suitable for a porous film of an electrode of the solar cell, the titanium dioxide particle is used. Now, as the electrode of the dye-sensitized solar cell, a porous electrode comprising a sintered body of an anatase type $TiO_2$ is widely used.
On the other hand, the other type dye-sensitized solar cell is developed, where a second metal oxide thin film such as $SiO_2$ $Al_2O_3$, $ZrO_2$ or the like is coated on a $TiO_2$ film. (for example, referring to Journal of American Chemical Society, 2, 125, 2003, P475-482) In this dye-sensitized solar cell, a cell performance can be improved rather than a solar cell using only the $TiO_2$ film. In addition, the second metal oxide thin film is formed by dipping the $TiO_2$ film in a precursor solution of the metal oxide and sintering it.

### DISCLOSURE OF INVENTION

### PROBLEMS TO BE SOLVED BY THE INVENTION

However, in the conventional dye-sensitized solar cell indicated in the above non-patent reference, there is a problem that the thickness of the whole of the cell is increased since the second metal oxide thin film is formed on the $TiO_2$ film.
Further, in the conventional dye-sensitized solar cell indicated in the above non-patent reference, there is another problem that a number of the production process is increased since the $TiO_2$ film must be dipped in the precursor solution of the metal oxide to form the second metal oxide thin film.
The object of the present invention is to provide a photovoltaic device capable of improving short circuit current density and photon-to-electron conversion efficiency without increasing the thickness of the whole of the cell and the number of the production process. Further, the object of the present invention is also to provide a manufacturing method of a titanium dioxide particle used for making the photovoltaic device, and a dye-sensitized solar cell using this photovoltaic device.

### MEANS FOR SOLVING PROBLEM

The invention according to claim 1 is the improved photovoltaic device comprising a light-transmittable base material 31, and a porous film 41 b formed on the base material and adsorbing a dye 41d, as shown in Figure 1.
The characteristic of this invention is that the porous film 41b adsorbing the dye 41 d contains a titanium dioxide particle 41 c containing aluminum oxide.
In the photovoltaic device described in claim 1, since the titanium dioxide particle 41c contains aluminum oxide, it is prevented to backwardly flow an electron (e-) generated at the dye 41d to an electrolyte solution 33, so that the photon-to-electron conversion efficiency of the photovoltaic device 30 is improved.
The invention according to claim 2 is the invention according to claim 1, and further has the characteristic that the titanium dioxide particle is a titanium dioxide particle doped with aluminum oxide.
In the photovoltaic device described in claim 2, since the titanium dioxide particle is doped with aluminum oxide, it is prevented to backwardly flow an electron (e-) generated at the dye to the electrolyte solution, so that the photon-to-electron conversion efficiency of the photovoltaic device is improved.
The invention according to claim 3 is the invention according to claim 1, and further has the characteristic that the titanium dioxide particle 41 c is a mixed particle of a first titanium dioxide particle and a second titanium dioxide particle, as shown in Figure 1. The first titanium dioxide particle is doped with aluminum oxide, and the second titanium dioxide particle is not doped with aluminum oxide.
In the photovoltaic device described in claim 3, since the titanium dioxide particle 41 c contains the first titanium dioxide particle doped with aluminum oxide, it is prevented to backwardly flow the electron generated at the dye 41d to the electrolyte solution 33, so that the photon-to-electron conversion efficiency of the photovoltaic device 30 is improved.

Further, since the titanium dioxide particle 41c contains the second titanium dioxide particle not doped with aluminum oxide, a specific surface area per unit volume of the porous film 41 b is increased, the amount of the adsorbed dye is increased, and short circuit current density becomes high. Thus, the photon-to-electron conversion efficiency is improved. Further, when the mixing ratio of one kind of the first titanium dioxide particle and one kind of the second titanium dioxide particle is changed, the content of aluminum oxide in the titanium dioxide particle 41c can be easily adjusted, where the first titanium dioxide particle is doped with the predetermined amount of aluminum oxide, and the second titanium dioxide particle is not doped with aluminum oxide.

The invention according to claim 7 is a manufacturing method of the titanium dioxide particle used for making the photovoltaic device described in any one of claim 1 to claim 6. This method comprises a process for preparing a first mixed gas by uniformly mixing a titanium tetrachloride gas, an aluminum chloride gas, oxygen and hydrogen; a process for making the first titanium dioxide particle doped with 0.01 to 1wt. % aluminum oxide by flame-hydrolyzing the first mixed gas; a process for preparing the second mixed gas by uniformly mixing a titanium tetrachloride gas, oxygen and hydrogen; a process for making the second titanium dioxide particle by flame-hydrolyzing the second mixed gas; and a process for preparing the titanium dioxide particle by mixing the first titanium dioxide particle and the second titanium dioxide particle with a predetermined ratio.

In the manufacturing method of the titanium dioxide particle described claim 7, there are no agglomerations, and it is possible to make the titanium dioxide particle having excellent dispersibility to an acid solution.

The invention according to claim 8 is a dye-sensitized solar cell using the photovoltaic device 30 described in any one of claim 1 to claim 7, as shown in Figure 1.

In the dye-sensitized solar cell described in claim 8, since the titanium dioxide particle 4 1 c contains aluminum oxide, it is prevented to backwardly flow the electron (e-) generated at the dye 41d to the electrolyte solution 33, so that the photon-to-electron conversion efficiency of the photovoltaic device 30 is improved. More particularly, since the titanium dioxide particle 4 1 c contains the first titanium dioxide particle doped with aluminum oxide, it is prevented to backwardly flow the electron (e-) generated at the dye 41d to the electrolyte solution 33, so that the photon-to-electron conversion efficiency of the photovoltaic device 30 is improved. Further, since the titanium dioxide particle 4 1 c contains the second titanium dioxide particle which is not doped with aluminum oxide, the specific surface area per unit volume of the porous film 41b is increased, the amount of the adsorbed dye is increased, and the short circuit current density becomes high. Thus, the photon-to-electron conversion efficiency is improved.

## EFFECT OF THE INVENTION

As mentioned above, according to the present invention, since the porous film of the photovoltaic device contains the titanium dioxide particle containing aluminum oxide, it is prevented to backwardly flow the electron generated at the dye to the electrolyte solution. As a result, the photon-to-electron conversion efficiency of the photovoltaic device can be improved.

Further, when the titanium dioxide particle is the mixed particle of the first titanium dioxide particle and the second titanium dioxide particle, where the first titanium dioxide is doped with aluminum oxide and the second titanium dioxide is not doped with aluminum oxide, since the titanium dioxide particle contains the first titanium dioxide particle doped with aluminum oxide, it is prevented to backwardly flow the electron generated at the dye to the electrolyte solution, so that the photon-to-electron conversion efficiency of the photovoltaic device is improved. Further, since the titanium dioxide particle contains the second titanium dioxide particle not doped with aluminum oxide, the specific surface area per unit volume of the porous film is increased, the amount of the adsorbed dye is increased, and the short circuit current density becomes high. Thus, the photon-to-electron conversion efficiency is improved. Further, when the mixing ratio of one kind of the first titanium dioxide particle and one kind of the second titanium dioxide particle is changed, the content of aluminum oxide in the titanium dioxide particle can be easily adjusted, where the first titanium dioxide particle is doped with the predetermined amount of aluminum oxide, and the second titanium dioxide particle is not doped with aluminum oxide. Thereby, it is possible to easily make the titanium dioxide containing the desired amount of aluminum oxide.

Further, it is possible to make the titanium dioxide particle having the excellent dispersibility to an acidic aqueous solution and a purity of 99.0% or more, where the agglomeration is not generated and chlorine with which it is difficult to treat is not generated. The manufacturing method of this titanium dioxide particle comprises, preparing the first mixed gas by uniformly mixing the titanium tetrachloride gas, the aluminum chloride gas, oxygen and hydrogen, making the first titanium dioxide particle doped with 0.01 to 1 wt.% aluminum oxide by flame-hydrolyzing the first mixed gas, preparing the second mixed gas by uniformly mixing the titanium tetrachloride gas, oxygen and hydrogen, making the second titanium dioxide particle by flame-hydrolyzing the second mixed gas, and preparing the titanium dioxide particle by mixing the first titanium dioxide particle and the second titanium dioxide particle with the predetermined ratio.

Further, as for the dye-sensitized solar cell using the photovoltaic device, since the titanium dioxide particle contains aluminum oxide, that is, the titanium dioxide particle contains the first titanium dioxide particle doped with aluminum oxide, it can be prevented to backwardly flow the electron generated at the dye to the electrolyte solution. Furthermore, since the titanium dioxide particle contains the second titanium dioxide particle not doped with aluminum oxide, the specific surface area per unit volume of the porous film is increased and the amount of the adsorbed dye is increased. As a result, the short circuit current density becomes high, so that the photon-to-electron conversion efficiency becomes high.

BRIEF DESCRIPTION OF DRAWINGS

Fig.1 is a cross-sectional constitution figure of a dye-sensitized solar cell using a photovoltaic device containing a titanium dioxide particle of the preferred embodiment of the present invention.
Fig.2 is a constitution figure of a manufacturing method of a first titanium dioxide particle doped with aluminum oxide.
Fig.3 is a constitution figure of a manufacturing method of a second titanium dioxide particle not doped with aluminum oxide.
Fig.4 is a constitution figure of the other manufacturing method of the fist titanium dioxide particle doped with aluminum oxide.
Fig.5 is a figure showing a variation of photon-to-electron conversion efficiencies with the content of aluminum oxide.

EXPLANATIONS OF LETTERS OR NUMERALS

30: Photovoltaic device
31: First base material (base material)
41b: Porous film
41c: Titanium dioxide particle
41d: Dye
50: Dye-sensitized solar cell

BEST MODE (S) FOR CARRYING OUT THE INVENTION

Then, the detailed description of the preferred embodiment of the present invention is explained based on drawings.
The titanium dioxide particle of the preferred embodiment (a titania ($TiO_2$) particle) is the mixed particle of the first titanium dioxide particle doped with aluminum oxide and the second titanium dioxide particle not doped with aluminum oxide. The aluminum oxide doped to the first titanium dioxide is $Al_2O_3$. The content of aluminum oxide in the titanium dioxide particle is 0.0005 to 0.01 wt.%, and preferably 0.0007 to 0.005 wt.%. The content of aluminum oxide in the titanium dioxide particle is adjusted, for example, by changing the mixing ratio of the first titanium dioxide particle doped with the 0.1 wt.% aluminum oxide and the second titanium dioxide particle not doped with aluminum oxide. The advantage of this method is as follows, that is, the content of aluminum oxide in the titanium dioxide particle can be adjusted by only using two kinds of titanium dioxide particles, and the titanium dioxide particle containing aluminum oxide with the predetermined amount can be easily made, wherein the two kinds of titanium dioxide particles is the first titanium dioxide particle doped with the 0.1 wt.% aluminum oxide and the second titanium dioxide particle not doped with aluminum oxide. In addition, in the present preferred embodiment, although the doping amount of aluminum oxide in the first titanium dioxide particle is set to 0.1 wt.%, it is not limited by this amount. However, it is preferable that the doping amount of aluminum oxide to the first titanium dioxide particle is within the range of 0.01 to 1 wt.%, from the point of the easy manufacturing and operating, or the like.
On the other hand, the reason why the content of aluminum oxide in the titanium dioxide particle is limited within the range of 0.0005 to 0.01 wt.% is as follows, that is, the efficiency of the photovoltaic device containing the above titanium dioxide particle becomes to be low if the content is outside the above-mentioned range. Further, the first titanium dioxide particle has a crystalline anatase being 70 to 95 wt%, preferably 75 to 90 wt%, a specific surface area by the BET method being 35 to 65 $m^2/g$, preferably 45 to 55 $m^2/g$, and an oil absorption being 55 to 75 ml/100g measured by the method according to JIS K5101, preferably 60 to 70 ml/100g. At this time, the reason why the specific surface area by the BET method of the first titanium dioxide particle is limited within the range from 35 to 65 $m^2/g$ is as follows, that is, the particle size of the first titanium dioxide particle is increased too much if the specific surface area is less than 35 $m^2/g$, and the productivity of the first titanium dioxide is remarkably decreased if the specific surface area is more than 65 $m^2/g$. Furthermore, the reason why the oil absorption of the first titanium dioxide particle is limited within the range from 55 to 75 ml/100g is, as follows, that is, a viscosity of a paste prepared using the acidic aqueous solution (hereinafter, this paste is said to as an acidic aqueous paste), in which the first titanium dioxide particle is dispersed, becomes too low if the oil absorption is less than 55 ml/ 100g, and the viscosity of the acidic aqueous paste becomes too high if the oil absorption is more than 75 ml/100g.
The manufacturing methods of the first and second titanium dioxide particles constituted in this way are explained.

(a) Manufacturing method of the first titanium dioxide particle

The manufacturing equipment 10 of the first titanium dioxide particle comprises a burner 11 for making an oxide by a thermal decomposition method, as shown in Figure 2. The burner 11 comprises a tapered housing 12, a central tube 13, and a nozzle 13a. The central tube 13 is inserted from a base end of the housing 12 and extends to a center of the housing 12 on a central line of the housing 12. The nozzle 13a is provided at a top end of the central tube 13 and opened in the housing 12. With near the base end of the central tube 13, a first introduction tube 21 is connected. A mixed raw material gas comprising the titanium tetrachloride gas, hydrogen and air (oxygen) is introduced into the central tube 13 through the first introduction tube 21. This mixed raw material gas is injected to the inside of the housing 12 from the nozzle 13a, and combusted in a combustion chamber 14 and a flame tube 16 connected to the combustion chamber 14. The flame tube 16 is surrounded by a water cooling jacket 17, and the inside of the flame tube is cooled by passing the cooling water in the water cooling jacket 17. Further, the central tube 13 is surrounded by an annular tube 18, and the nozzle 13a is surrounded by an annular nozzle 18a provided at a top end of the annular tube 18. With near a base end of the annular tube 18, a second introduction tube 22 is connected and a secondary hydrogen gas is introduced into the annular nozzle 18a through the second introduction tube 22 and the annular tube 18. A burning of the nozzle 13a can be avoided by introducing this secondary hydrogen gas.
On the other hand, an axial flow tube 19 is inserted into the central tube 13. A base end of the axial flow tube 19 is connected with an aerosol generator 23, and a top end of the axial flow tube 19 is opened in the central tube 13. The first mixed gas is made by making an aerosol comprising aluminum trichloride and water, feeding to the central tube 13 through the axial flow tube 19, and uniformly mixing with the above-mentioned mixed raw material gas before reacting. The aerosol is made by an ultrasonic spraying or the like of an aqueous solution or dispersion liquid of aluminum trichloride (aluminum chloride) in the aerosol generator 23. When this first mixed gas is combusted in the combustion chamber 14 and the flame tube 16, the first titanium dioxide particle doped with aluminum oxide is generated. The obtained first titanium dioxide particle doped with aluminum oxide is separated and recovered from an outflow gas by a commonly known method.
In addition, it is supposed that when the aerosol comprising aluminum trichloride and water, which is generated in the aerosol generator 23, is fed to a heat zone 24 through the axial flow tube 19 with a mild career gas flow, the entrained water in the aerosol is evaporated in the heat zone 24, and then, the aerosol becomes the condition in which a fine salt crystal is finely dispersed in a gas phase. The aerosol having the condition, in which the fine salt crystal is finely dispersed in the gas phase, is uniformly mixed with the above-mentioned mixed raw material gas in the central tube 13 through the axial flow tube 19 to become the first mixed gas. When the first mixed gas is reacted in a flame, it is possible to make the first titanium dioxide particle which is doped with aluminum oxide and has the specific surface area by the BET method being 35 to 65 $m^2/g$. Therefore, as for the first titanium dioxide particle doped with aluminum oxide being made in this way, the existing state of aluminum oxide is clearly different from that of the mixed oxide by the thermal decomposition method, which is commonly known, that is, a co-fumed method. In this co-fumed method, $TiCl_4$ gas and $AlCl_3$ gas are only premixed and combusted together in a flame reactor.

(b) Manufacturing method of the second titanium dioxide particle

In order to make the second titanium dioxide particle not doped with aluminum oxide, the second mixed gas (the mixed raw material gas) is prepared by heating a high purity titanium tetrachloride liquid to be vaporized at first, and mixing the vaporized titanium tetrachloride gas with hydrogen and air. Then, the second titanium dioxide particle having the specific surface area by the BET method being 65 to 120 $m^2/g$ is made by flame-hydrolyzing the second mixed gas in the flame in which hydrogen and oxygen are combusted. In addition, a theoretical combustion temperature of the flame is set to as 400 to 700 , and preferably 450 to 600 . At this time, the reason why the theoretical combustion temperature of the flame is set within the range of 400 to 700 is as follows, that is, the productivity of the second titanium dioxide particle is remarkably decreased if it is less than 400 , and the particle size of the made second titanium dioxide particle is increased if it is more than 700 .
The manufacturing method of the second titanium dioxide particle by the flame hydrolysis method is explained concretely. As shown in Figure 3, the second mixed gas is prepared by vaporizing titanium tetrachloride in an evaporator 71 at first, feeding it to a mixer 72, and mixing the vaporized titanium tetrachloride gas with oxygen (air) in the mixer 72. Then, the second mixed gas is fed to a burner 73 together with hydrogen, and combusted. That is, the second titanium dioxide particle and a by-product (hydrochloric acid) are generated by flame-hydrolyzing titanium tetrachloride at the burner 73.

Further, these second titanium dioxide particle and by-product are cooled in a cooling zone 74, and the hydrochloric acid being the by-product is removed by a hydrochloric acid separator 76. The second titanium dioxide particle, in which hydrochloric acid is removed, is stored at a storage silo 77. In addition, the particle size of the obtained second titanium dioxide particle can be controlled by changing the conditions of the flame hydrolysis, for example, the feeding amount of the titanium tetrachloride gas, oxygen (air), hydrogen, or the like.

The manufacturing method of the photovoltaic device using the titanium dioxide particle, in which the first titanium dioxide particle and the second titanium dioxide particle are mixed, is explained.

A first conductive film 41 a is formed on a first base material 31 at first (Figure 1). As the first base material 31, it is preferable to use a glass plate having light transmissivity, or a plastic film having light transmissivity and flexibility. As the first conductive film 41a, it is preferable to use a FTO film in which tin oxide is doped with fluorine or an ITO film in which indium oxide is mixed with a little amount of tin oxide. Further, the first conductive film 41a is formed on one surface, both surfaces, or a whole surface of the first base material 31 by a vapor deposition method, a sputtering method, an ion plating method, a hydrolyzing method or the like. It is preferable that the first conductive film 41a has a surface resistivity of 5 to 15Ω/□.

Then, a titanium dioxide paste containing the titanium dioxide particle 41 c is coated on the first conductive film 41a, and heated and calcined. This titanium dioxide paste is prepared by uniformly mixing the made titanium dioxide particle 4 1 c using the above equipment, an acidic aqueous solution, a thickening agent and a dispersing agent. As the acidic aqueous solution, nitric acid, hydrochloric acid, sulfuric acid or the like can be used, and it is preferable that pH of the acidic aqueous solution is 3 or less. The reason why the pH of the acidic aqueous solution is 3 or less is that an interfacial potential of the titanium dioxide particle 41c is controlled to increase the dispersibility of the titanium dioxide particle 4 1 c. Further, as the thickening agent, glycols such as polyethylene glycol or the like is used. As the dispersing agent, acetylacetone and Triton-X100 (an alkylphenoxypolyethylene glycol type nonionic surfactant) are used. The reason why polyethylene glycol is added as the thickening agent is as follows, that is, the viscosity of the titanium dioxide paste can be increased to form the thick film, and when the polyethylene glycol is evaporated during heating the titanium dioxide paste, a penetration hole can be formed, where the hole is penetrated from the front surface to back surface of the porous film 41 b containing the titanium dioxide particle 41 c. Further, a bonding strength between the porous film 41b and the first conductive film 41a can be increased. When the Triton-X100 is used as the dispersing agent, there is an advantage that a residual component is not remained after heating.

Then, a forming method of the porous film 41b is explained. When the glass plate is used as the first base material 31, the porous film 41 b is formed by coating and drying the titanium dioxide paste on the first conductive film 41a using a doctor blade method, a squeegee method, a spin coat method, a screen printing method or the like, taking it into an electric furnace, and calcining it in an atmosphere while keeping 300 to 600 for 30 to 90 minutes. Thereby, the forming process for the porous film 41 b on the first conductive film 41a is completed. At this time, the reason why the calcining temperature is limited within the range of 300 to 600 is as follows, that is, if this temperature is less than 300 , there are problems that an organic additive which cannot be combusted is remained to prevent the adsorption of the dye, and the high photon-to-electron conversion ability cannot be obtained since the sintering of the titanium dioxide particle 41 c itself is insufficient. Further, if this temperature is more than 600 , there are problems that the base material 31 is softened to cause the trouble to make a working electrode 41. Furthermore, the reason why the calcining time is limited within the range of 30 to 90 minutes is as follows, that is, there is a problem of causing the insufficient sintering if it is less than 30 minutes, and the particle growth by calcining progresses is too much to decrease the specific surface area if it is more than 90 minutes. On the other hand, when the plastic film having the flexibility (for example, a polyethyleneterephthalate film) is used as the first base material, the porous film is formed by coating the titanium dioxide paste on the first conductive film of the first base material using a squeegee (applicator) method, a screen printing method, an electrodepositing method, a spray method, DJP (Direct jet printing) method or the like, carrying out a press forming if necessary, and then, irradiating a microwave. Thereby, the forming process for the porous film on the first conductive film is completed.

Then, the dye 41d is adsorbed to the porous film 41 b to be fixed by dipping the first base material 31 in a dye solution, where the porous film 41b is formed on the first conductive film 41 a. As the dye 41 d, it is preferable to use an organic dye having a photoelectric effect in addition to a ruthenium complex. More particularly, a methine dye, a xanthene-based dye, a porphyrin dye, a phthalocyanine dye, an azo-based dye, a coumarin dye or the like is preferably used. Further, a mixed dye of one or more than two kinds selected from a group consisting of these dyes may be used as a photon-to-electron conversion material. When the ruthenium complex is used as the dye 41d, the ruthenium complex is dissolved with an independent solvent of acetonitrile, t-BuOH, ethanol or the like or a mixed solvent of these solvents to prepare the dye solution, and the concentration of the dye solution is adjusted to have $3\times10^{-4}$ to $5\times 10^{-4}$mol. At this time, the reason why the concentration of the dye solution is limited within the range of $3\times10^{-4}$ to $5\times10^{-4}$ mol is as follows, that is, if it is less than $3\times10^{-4}$ mol, there is a problem that the amount of the adsorbed dye is insufficient and the photon-to-electron conversion efficiency decreases. If it is more than $5\times10^{-4}$ mol, it is difficult to improve the characteristics of the photon-to-electron conversion material even when adding the dye more since the concentration reaches the saturated condition. Further, the dipping time of the first base material 31 to the dye solution is about 20 hours at a room temperature in general. Although the dipping time of the first base material 31 to the dye solution is about 20 hours, this time can be shortened to about 5 minutes at the shortest by heating and refluxing the dye solution to near the boiling point. It should be took care suitably so as to make the amount of the adsorbed dye into the maximum on balance with the operation time by considering the film thickness of the titanium dioxide particle 41c, a damaging risk of the electrode, or the like. Furthermore, the surface of the porous film 41b adsorbed with the dye is washed and dried. Thereby, the photovoltaic device 30 can be made.
In the conventional photovoltaic device comprising the titanium dioxide particle not containing aluminum oxide, although almost all electrons (e-) generated at the dye is transferred to the titanium dioxide particle quickly, a part of the electron (e-) is transferred to the electrolyte solution, so that the photon-to-electron conversion efficiency of the photovoltaic device is a little low.
However, in the photovoltaic device 30 of the present invention, since the titanium dioxide particle 4 1 c contains aluminum oxide, that is, the titanium dioxide particle 41c contains the first titanium dioxide particle doped with aluminum oxide, it can be prevented to backwardly flow the electron (e-) generated at the dye 41d to the electrolyte 33. Further, since the titanium dioxide particle 41c contains the second titanium dioxide particle not doped with aluminum oxide, the specific surface area per unit volume of the porous film 41 b is increased, and the amount of the adsorbed dye is increased. As a result, the short circuit current density becomes high, so that the photon-to-electron conversion efficiency becomes high.

Then, a manufacturing method of a dye-sensitized solar cell 50 using the photovoltaic device 30 is explained. A counter electrode 42 is formed by forming a second conductive film 42a on a second base material 32. The second conductive film 42a is formed on one surface, both surfaces, or a whole surface of the second base material 32 by the vapor deposition method, the sputtering method, the ion plating method, the hydrolyzing method or the like. As the second base material 32, it is preferable to use the glass plate or the plastic film having the flexibility. As the second conductive film 42a, it is preferable to use a film, in which one or more kinds selected from the following group are laminated, that is, the group consisting of a platinum foil, a FTO film in which tin oxide is doped with fluorine, or a ITO film in which indium oxide is mixed with a little amount of tin oxide.
The electrolyte solution 33 is stored between the working electrode 41 and the counter electrode 42, while having the predetermined space between the working electrode 41 of the first base material 31 and the counter electrode 42 of the second base material 42. The electrolyte solution 33 is prepared by mixing a supporting electrolyte, a redox pair and an alcohol-based or nitrile-based independent solvent or a mixed solvent of them. The supporting electrolyte comprises a positive ion, such as a lithium ion, a negative ion, such as a chlorine ion, or the like. The redox pair is an iodine- iodine compound, a bromine- bromine compound, which exist in the supporting electrolyte. The alcohol-based solvent is ethanol or t- butanol, and the nitrile-based solvent is acetonitrile, methoxyacetonitrile or 3- methoxypropionitrile. In addition, in order to keep the space with a predetermined value between the working electrode 41 of the first base material 31 and the counter electrode 42 of the second base material 32, a spacer (which is not shown in this drawing) made with a resin film having a thickness of 10 to 30μm is interposed between the working electrode 41 and the counter electrode 42. Further, in order to prevent the leakage of the electrolyte solution 33, an electrically insulating adhesive, such as an epoxy resin or the like, is coated to the periphery of these electrodes at between the working electrode 41 and the counter electrode 42, and hardened. Thereby, the dye-sensitized solar cell 50 is made.

In the dye-sensitized solar cell made in this way, since the titanium dioxide particle 41c contains aluminum oxide, that is, the titanium dioxide particle 41c contains the first titanium dioxide particle doped with aluminum oxide, it can be prevented to backwardly flow the electron (e-) generated at the dye 41d to the electrolyte 33. Further, since the titanium dioxide particle 41c contains the second titanium dioxide particle not doped with aluminum oxide, the specific surface area per unit volume of the porous film 41b is increased, and the amount of the adsorbed dye is increased. As a result, the short circuit current density becomes high, so that the photon-to-electron conversion efficiency becomes high.

In addition, in this preferred embodiment, the titanium dioxide particle is the mixed particle of the first titanium dioxide particle doped with aluminum oxide and the second titanium dioxide not doped with aluminum dioxide. However, the titanium dioxide particle may comprises only a titanium dioxide particle doped with aluminum oxide of 0.0005 to 0.01 wt.%, preferably 0.007 to 0.005 wt.%. This titanium dioxide particle doped with aluminum oxide is made by the manufacturing equipment of the first titanium dioxide particle, which is shown in Figure 2.
Further, in this preferred embodiment, although the first titanium dioxide particle is made by the manufacturing equipment shown in Figure 2, this particle may be made using the manufacturing equipment 80 shown in Figure 4. In Figure 4, the same marks as those of Figure 3 show the same parts as those of Figure 3. More particularly, as shown in Figure 4, the first mixed gas is prepared by vaporizing titanium tetrachloride using the evaporator 71 at first, vaporizing aluminum trichloride (aluminum chloride) using an evaporator 81, feeding these gases to the mixer 72, and mixing the vaporized titanium tetrachloride gas and aluminum trichloride gas with oxygen (air) in the mixer 72. Then, the first mixed gas is fed to the burner 73 together with hydrogen and combusted. That is, when titanium tetrachloride and aluminum trichloride are flame-hydrolyzed by the burner 73, the first titanium dioxide particle doped with aluminum oxide and the by-product (hydrochloric acid) are made. Further, after the first titanium dioxide doped with aluminum oxide and the by-product are cooled in the cooling zone 74, the hydrochloric acid being the by-product is removed by the hydrochloric acid separator 76. The first titanium dioxide doped with aluminum oxide, in which hydrochloric acid is removed, is stored in a storage silo 77. In addition, the obtained particle size of the first titanium dioxide particle can be controlled by changing the conditions of the flame hydrolysis, for example, the feeding amount of the titanium tetrachloride gas, oxygen (air) and hydrogen, or the like. Furthermore, the doping amount of aluminum oxide to the first titanium dioxide particle can be controlled by changing the feeding amount of the aluminum trichloride gas.

Examples

Then, examples of the present invention are explained concretely with comparison examples.

<Example 1>

The first titanium dioxide particle doped with 0.1 wt.% aluminum oxide and having the specific surface area by the BET method being 50 $m^2/g$ was made at first, using the manufacturing equipment 10 of the first titanium dioxide particle shown in Figure 2, generating the aerosol by ultrasonic-spraying an aluminum chloride aqueous solution, uniformly mixing the aerosol passing through the heat zone 24 with the mixed gas of the titanium tetrachloride gas, oxygen and hydrogen to prepare the first mixed gas, and flame-hydrolyzing the first mixed gas ($TiCl_4$ $H_2$ $O_2$ $AlCl_3$ $H_2O$). Then, the second titanium dioxide particle having the specific surface area by the BET method being 90 $m^2/g$ was made, using the manufacturing equipment 70 of the second titanium dioxide particle shown in Figure 3, mixing the raw material gasses to prepare the second mixed gas, introducing the second mixed gas (the mixed raw material gas) into the burner 73, and flame-hydrolyzing it, wherein the raw material gasses were mixed so as to have the flowing rate of titanium tetrachloride being 110 kg/hour, hydrogen being 30 $Nm^3$/hour and air being 600 $Nm^3$/hour. The 1 wt.% first titanium dioxide particle and the 200 wt.% second titanium dioxide particle were mixed to prepare the titanium dioxide particle in which the content of aluminum oxide was diluted to 0.0005 wt.%. Then, the titanium oxide paste was prepared by taking 2.1g of the powder comprising the titanium dioxide particle, 4.9g of a nitric acid water having pH being 0.7, 0.21g of acetylacetone, 0.105g of polyethylene glycol having an average molecular weight of 500,000, one drop of Triton-X100 being diluted to 1/10, and 20g of zirconia beads having a diameter of 3 mm, into a covered polytetrafluoroethylene tube having a capacity being 30 ml, and carrying out a shaking treatment by a paint shaker for 6 hours.

The titanium dioxide paste was coated in a square shape on the first conductive film 41 a of the first base material 31 having the first conductive film 41a (Figure 1), wherein the square shape had the length and width of 5mm respectively. The first base material 31 having the first conductive film 41a is a glass plate produced by Nippon Sheet Glass Corporation, in which the first conductive film 41 a (the film in which tin oxide is doped with fluorine) is vapor-deposited on one surface of the glass plate having the thickness being 1.1 mm. The surface resistivity of the first conductive film is 15Ω/□. Then, the porous film 41b comprising the titanium dioxide particle 41 c containing aluminum oxide was made on the first conductive film 41 a, by taking the first base material 31 having the first conductive film 41a into the electronic furnace, where the first conductive film 41a was coated with the titanium dioxide paste, and keeping and calcining it at 500 under an atmosphere for 30 minutes. Further, Ruthenium535-bisTBA was used as the dye 41d, and the dye 41d was dissolved with the mixed solvent of acetonitrile and t-BuOH, and the dye solution was adjusted to have the concentration being $5\times10^{-4}$ mol. The first base material 31 was dipped in the dye soultuion for 12 hours to adsorb the dye 41d to the porous film 41 b. The surface of the porous film 41 b adsorbed with the dye 41d was washed with the acetonitrile and dried. Thereby, the photovoltaic device 30 was made, in which the working electrode 41 comprising the first conductive film 41a, the porous film 41 b and the dye 41 d was formed on the first base material 31.

On the other hand, the counter electrode 42 was made by forming the second conductive film 42a on one surface of the second base material 32 comprising the glass plate. The second conductive film was not shown in this drawing, but comprised a fluorine doped tin oxide layer and a platinum layer. The fluorine doped tin oxide layer was laminated on the second base material 32 by the vapor deposition method, and the platinum layer was laminated on the fluorine doped tin oxide layer by the sputtering method. As the spacer made by the resin film, a "Himilan" film produced by Dupont-Mitsui Polychemicals Corporation was used, and this film had a thickness being 25μm. Further, the electrolyte solution 33 was prepared by dissolving the following electrolytes with 3-methoxypropionitril as a solvent. That is, the electrolytes were 0.05 mol of iodine a solute, 0.1 mol of lithium iodide, 0.6 mol of 1,2-dimethyl-3-n-propylimidazolium iodide and 0.5 mol of tert-butyl-pyridine. Then, the dye-sensitized solar cell 50 was made by interposing the resin film spacer between the working electrode 41 and the counter electrode 42, and enclosing the electrolyte solution 33 between the both electrodes 41 and 42, where the resin film spacer was not shown in this drawing and formed with the Himilan film having the thickness being 25μm. This dye-sensitized solar cell 50 was named as Example 1. In addition, an effective area of the porous film 41b was 24.5 $mm^2$, and a film thickness of the porous film 41b was 8.1μm.

<Example 2>

The dye-sensitized solar cell was made like Example 1 except the 1 wt.% first titanium dioxide particle and 100 wt.% second titanium dioxide particle were mixed to prepare the titanium dioxide particle in which the content of aluminum oxide was diluted to 0.001 wt.%. This cell was named as Example 2. In addition, the effective area of the porous film was 24.0 $mm^2$, and the film thickness of the porous film was 7.8μm.

<Example 3>

The dye-sensitized solar cell was made like Example 1 except the 1 wt.% first titanium dioxide particle and 10 wt.% second titanium dioxide particle were mixed to prepare the titanium dioxide particle in which the content of aluminum oxide was diluted to 0.01 wt.%. This cell was named as Example 3. In addition, the effective area of the porous film was 24.0 $mm^2$, and the film thickness of the porous film was 8.1μm.

<Example 4>

The first titanium dioxide particle doped with 0.0005 wt.% aluminum oxide and having the specific surface area by the BET method being 50 $m^2/g$ was made at first, using the manufacturing equipment 10 of the first titanium dioxide particle shown in Figure 2, generating the aerosol by ultrasonic-spraying an aluminum chloride aqueous solution, uniformly mixing the aerosol passing through the heat zone 24 with the mixed gas of titanium tetrachloride, oxygen and hydrogen to prepare the first mixed gas, and flame-hydrolyzing the first mixed gas ($TiCl_4$ $H_2$ $O_2$ $AlCl_3$ $H_2O$). Then, the titanium oxide paste was prepared, taking 2.1g of the powder comprising the independent titanium dioxide particle doped with 0.0005 wt. % aluminum oxide, 4.9g of the nitric acid water having pH being 0.7, 0.21g of acetylacetone, 0.105g of polyethylene glycol having the average molecular weight of 500,000, one drop of Triton-X100 being diluted to 1/10, and 20g of zirconia beads having the diameter of 3 mm, into the covered polytetrafluoroethylene tube having a capacity being 30 ml, and carrying out a shaking treatment by a paint shaker for 6 hours. The dye-sensitized solar cell was made like Example 1 except the above-mentioned processes. This dye-sensitized solar cell was named as Example 4. In addition, the effective area of the porous film was 24.5$mm^2$, and the film thickness of the porous film was 9.4μm.

<Example 5>

The first titanium dioxide particle doped with 0.01 wt.% aluminum oxide and having the specific surface area by the BET method being 50 $m^2/g$ was made at first, using the manufacturing equipment 10 of the first titanium dioxide particle shown in Figure 2, generating the aerosol by ultrasonic-spraying an aluminum chloride aqueous solution, uniformly mixing the aerosol passing through the heat zone 24 with the mixed gas of titanium tetrachloride, oxygen and hydrogen to prepare the first mixed gas, and flame-hydrolyzing the first mixed gas ($TiCl_4$ $H_2$ $O_2$ $AlCl_3$ $H_2O$). Then, the titanium oxide paste was prepared, taking 2.1g of the powder comprising the independent titanium dioxide particle doped with 0.01 wt. % aluminum oxide, 4.9g of nitric acid water having pH being 0.7, 0.21g of acetylacetone, 0.105g of polyethylene glycol having the average molecular weight of 500,000, one drop of Triton-X100 being diluted to 1/10, and 20g of zirconia beads having the diameter of 3 mm, into the covered polytetrafluoroethylene tube having a capacity being 30 ml, and carrying out a shaking treatment by a paint shaker for 6 hours. The dye-sensitized solar cell was made like Example 1 except the above-mentioned processes. This dye-sensitized solar cell was named as Example 5. In addition, the effective area of the porous film was 24.3 $mm^2$, and the film thickness of the porous film was 10.2μm.

<Comparison example 1 >

The dye-sensitized solar cell was made like Example 1 except the second titanium dioxide particle not doped with aluminum oxide and having the specific surface area by the BET method being 90 $m^2/g$ was only used as the titanium dioxide particle. This dye-sensitized solar cell was named as Comparison example 1. In addition, the effective area of the porous film was 24.0 $mm^2$, and the film thickness of the porous film was 6.4μm.

<Comparison example 2>

The dye-sensitized solar cell was made like Example 1 except the 1 wt.% first titanium dioxide particle and the 1000 wt.% second titanium dioxide particle were mixed to prepare the titanium dioxide particle in which the content of aluminum oxide was diluted to 0.0001 wt.%. This cell was named as Comparison example 2. In addition, the effective area of the porous film was 24.3 $mm^2$, and the film thickness of the porous film was 8.2μm.

<Comparison example 3>

The dye-sensitized solar cell was made like Example 1 except the second titanium dioxide particle doped with 0.1 wt.% aluminum oxide was used as the titanium dioxide particle. This dye-sensitized solar cell was named as Comparison example 3. In addition, the effective area of the porous film was 24.0 $mm^2$, and the film thickness of the porous film was 7.7$\mu$m.

<Comparison experiment 1 and Evaluation>

Each of photon-to-electron conversion efficiencies $\eta$ (%) of the dye-sensitized solar cell of Examples 1 to 5 and Comparison examples 1 to 3 was measured respectively. This photon-to-electron conversion efficiency $\eta$ (%) was calculated from the following formula (1), using Voc (an open voltage value: V) taken by measuring an I-V curve characteristic, Isc (a short-circuit current value: mA), ff (a file factor value), L (an irradiation light amount: $mW/cm^2$), and S (an area of the porous film: $cm^2$).

$$\eta = (Voc \times Isc \times ff \times 100)/(L \times S) \qquad ..(1)$$

The results of these efficiencies were shown in Table 1 and Figure 5. In addition, the I-V curve characteristic was measured, using a solar simulator of 300W (produced by Oriel Corporation) as a light source, irradiating the light to the dye-sensitized solar cell so as to have the irradiation light amount of 100 $mW/cm^2$ [AM (air mass) 1.5G], and measuring I-V values using a potentiostat (HSV-100F produced by Hokuto Denko Corporation).

[Table 1]

| | Content of Aluminum Oxide (wt.%) | Porous Film | | Open Voltage Voc (V) | Short-circuit Current Density Isc ($mA/mm^2$) | File Facto r ff | Photon-to-electron Conversion Efficiency $\eta$ (%) |
|---|---|---|---|---|---|---|---|
| | | Effective Area ($mm^2$) | Thickness ($\mu$m) | | | | |
| Example 1 | 0.0005 (Mixing) | 24.5 | 8.1 | 0.770 | 11.11 | 0.67 4 | 5.76 |
| Example 2 | 0.001 (Mixing) | 24.0 | 7.8 | 0.772 | 12.90 | 0.65 5 | 6.52 |
| Example 3 | 0.01 (Mixing) | 24.0 | 8.1 | 0.736 | 11.36 | 0.69 2 | 5.78 |
| Example 4 | 0.0005 (Independent) | 24.5 | 9.4 | 0.745 | 10.58 | 0.68 5 | 5.40 |
| Example 5 | 0.01 (Independent) | 24.3 | 10.2 | 0.795 | 11.07 | 0.64 8 | 5.71 |
| Comparison example 1 | 0 | 24.0 | 6.4 | 0.744 | 10.75 | 0.66 7 | 5.33 |
| Comparison example 2 | 0.0001 (Mixing) | 24.3 | 8.2 | 0.765 | 10.64 | 0.65 7 | 5.35 |
| Comparison example 3 | 0.1 (Independent) | 24.0 | 7.7 | 0.753 | 9.74 | 0.67 4 | 4.94 |

Clearly from Table 1, although the photon-to-electron conversion efficiencies of Comparison examples 1 to 3 were low values 4.94 to 5.35 %, those of Examples 1 to 5 were high values 5.40 to 6.52 %. Further, clearly from Figure 5, the photon-to-electron conversion efficiencies were almost same when the content of aluminum oxide was increased at first. However, when the content of aluminum oxide was increased more than 0.0001 wt.%, the photon-to-electron conversion efficiency was remarkably increased, and reached to a peak when the content was 0.001 wt.%, and then, decreased in monotone.

INDUSTRIAL APPLICABILITY

The present invention does not increase the whole thickness of a photovoltaic device and the number of the production process, and can improve short circuit current efficiency. Therefore, the present invention can be applicable to a dye-sensitized solar cell.

## Claims

1. A photovoltaic device comprising a light-transmittable base material (31) and a porous film (41b) formed on the base material and adsorbing a dye (41d),
wherein said porous film (41 b) adsorbing said dye (41d) contains a titanium dioxide particle (4 1 c) containing aluminum oxide

2. The photovoltaic device according to claim 1, wherein the titanium dioxide particle is a particle doped with aluminum oxide.

3. The photovoltaic device according to claim 1, wherein the titanium dioxide (41c) is a mixed particle comprising a first titanium dioxide particle doped with aluminum oxide and a second titanium dioxide particle not doped with aluminum oxide.

4. The photovoltaic device according to claim 1, wherein the content of aluminum oxide in the titanium dioxide particle (41c) is 0.0005 to 0.01Wt. %.

5. The photovoltaic device according to claim 1, wherein the content of aluminum oxide in the titanium dioxide particle (41c) is 0.0007 to 0.005wt. %.

6. The photovoltaic device according to claim 1, wherein the base material (31) is a glass plate or a flexible plastic film.

7. A manufacturing method of the titanium dioxide particle used for the photovoltaic device according to any one of claim 1 to claim 6, the method comprising
a process for preparing a first mixed gas by uniformly mixing a titanium tetrachloride gas, an aluminum chloride gas, oxygen and hydrogen,
a process for making the first titanium dioxide particle doped with 0.01 to 1wt. % aluminum oxide by flame-hydrolyzing said first mixed gas,
a process for preparing a second mixed gas by uniformly mixing a titanium tetrachloride gas, oxygen and hydrogen,
a process for making the second titanium dioxide particle by flame-hydrolyzing said second mixed gas, and
a process for preparing the titanium dioxide particle by mixing said first titanium dioxide particle and said second titanium dioxide particle with a predetermined ratio.

8. A dye-sensitized solar cell using the photovoltaic device claimed in any one of claim 1 to claim 6.

Fig. 1

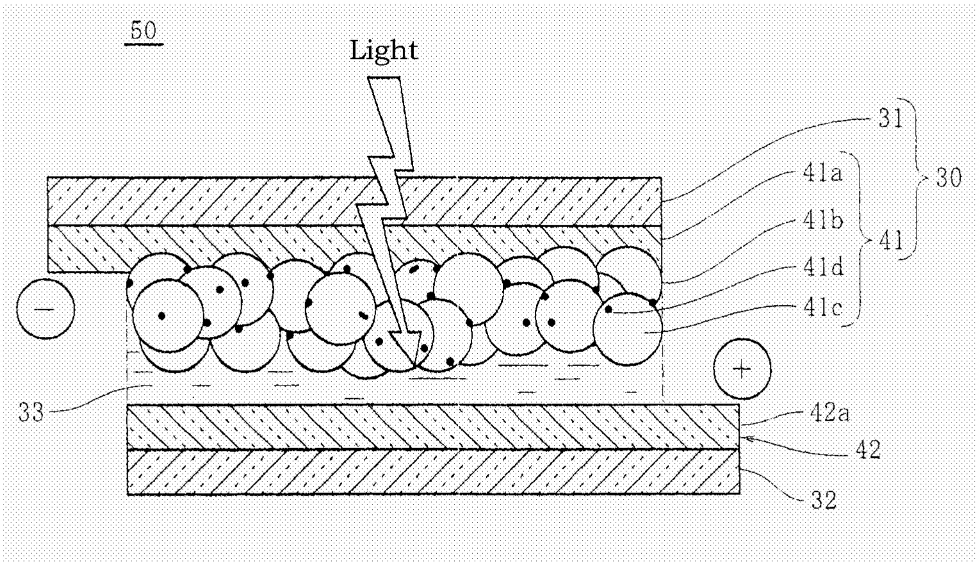


30: Photovoltaic device

31: First base material (base material)

41a: First conductive film

41b: Porous film

41c: Titanium dioxide particle

41d: Dye

50: Dye-sensitized solar cell

Fig. 2

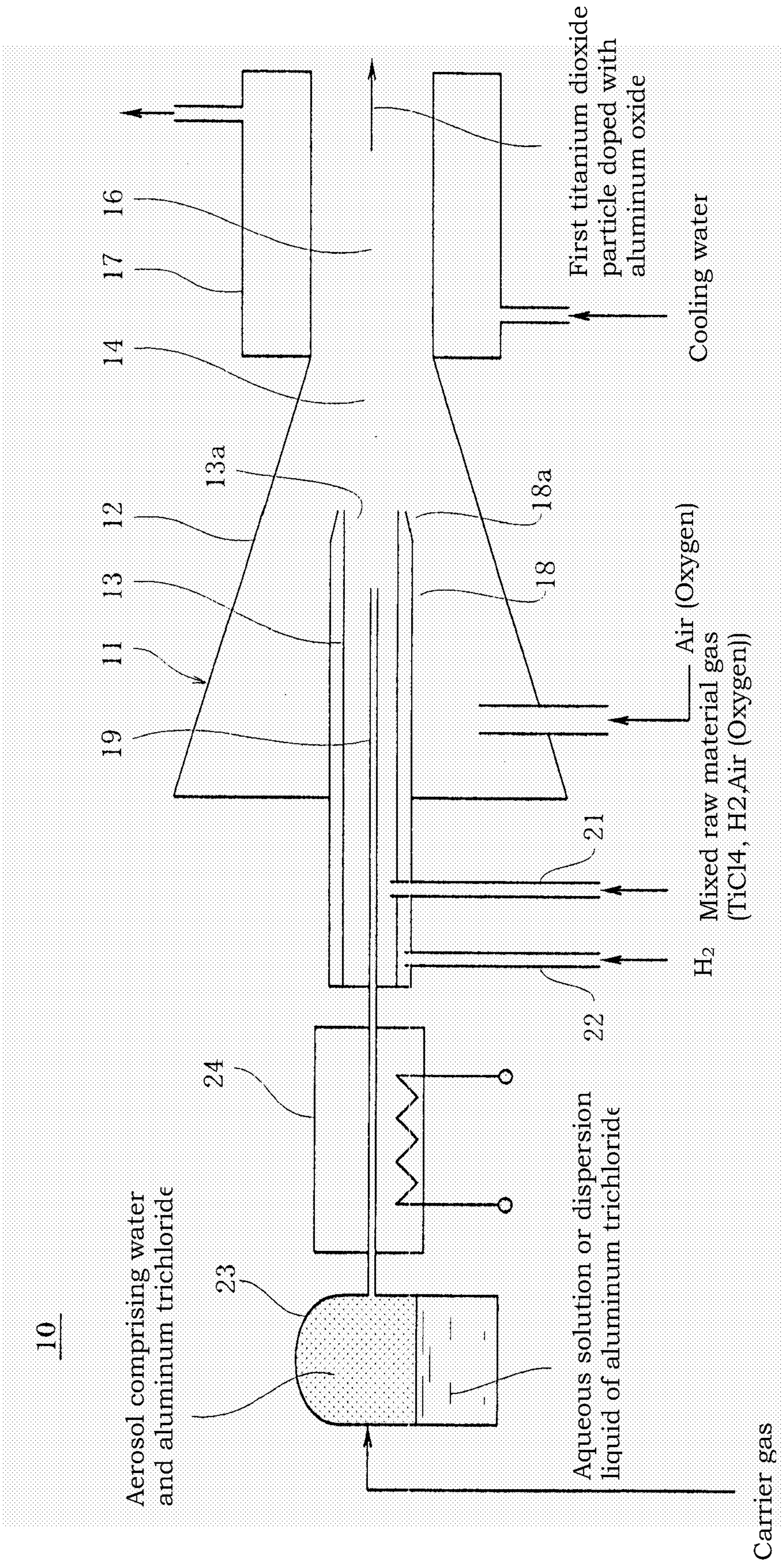
First titanium dioxide particle doped with aluminum oxide
Cooling water
16
17
14
13a
12
18a
13
18
11
19
Air (Oxygen)
Mixed raw material gas (TiCl4, H2,Air (Oxygen))
21
H2
22
24
Aerosol comprising water and aluminum trichloride
23
Aqueous solution or dispersion liquid of aluminum trichloride
10
Carrier gas

Fig. 3

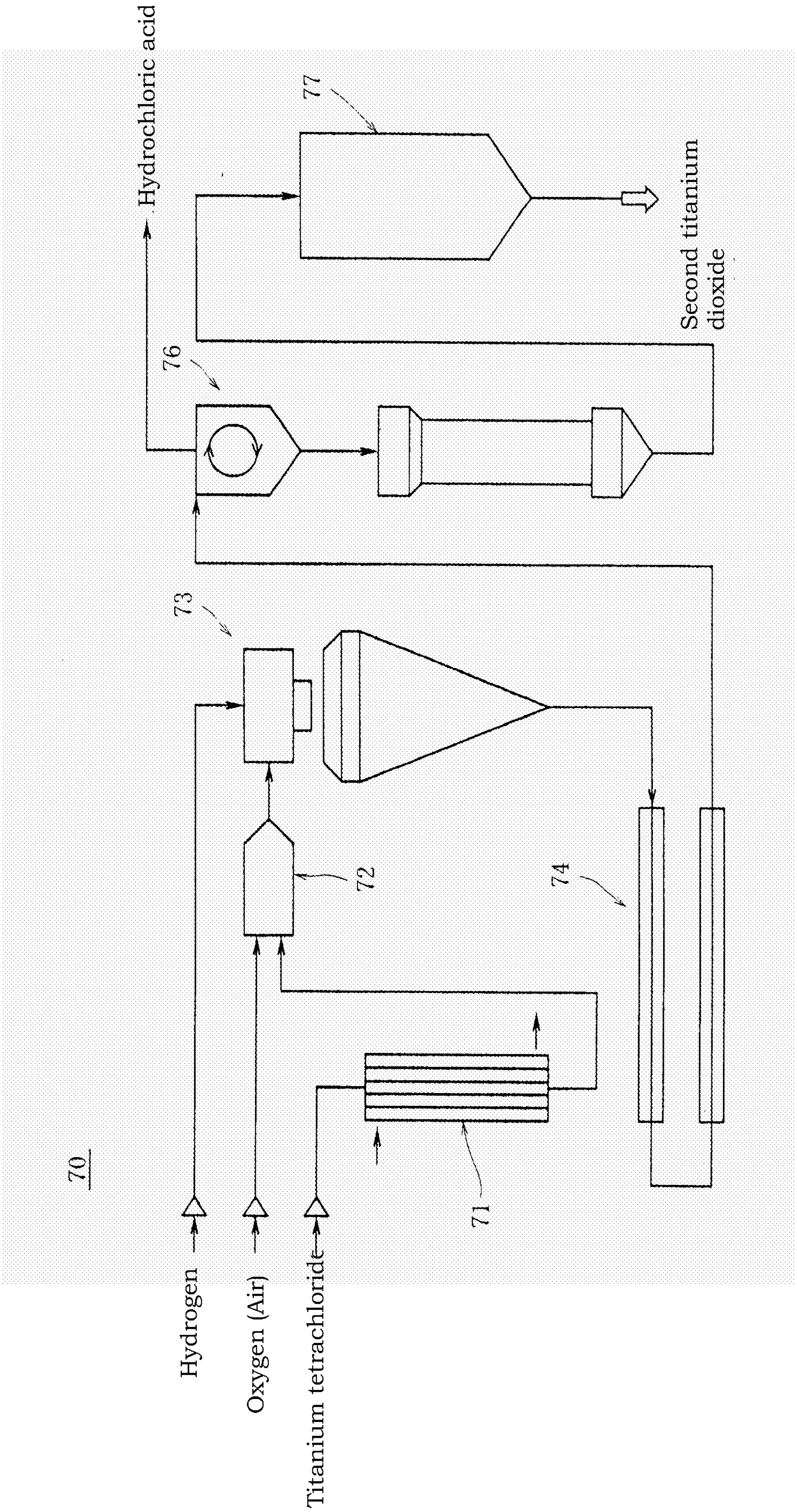
Hydrochloric acid
77
Second titanium dioxide
76
73
72
74
71
70
Hydrogen
Oxygen (Air)
Titanium tetrachloride

Fig. 4

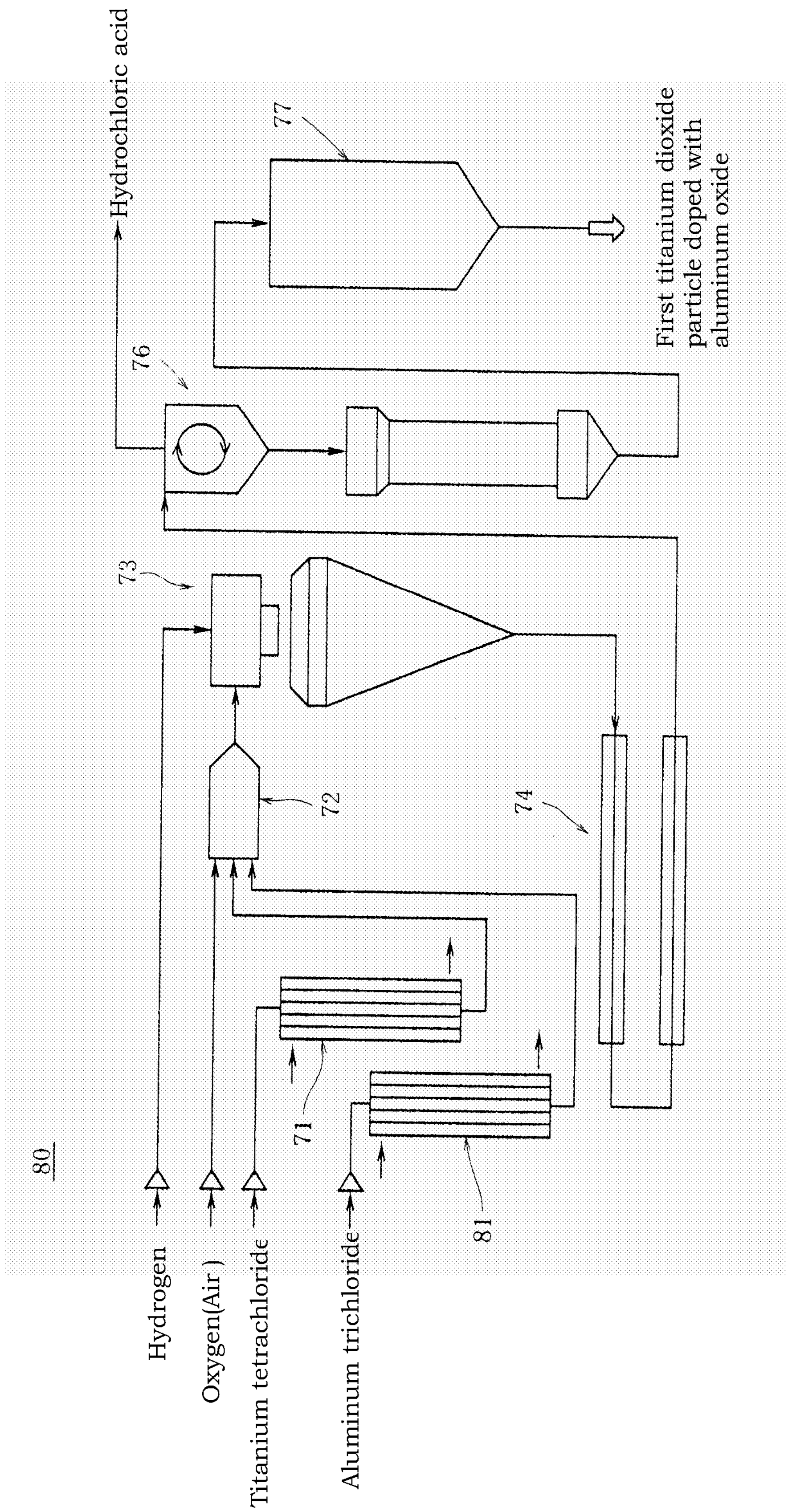
Hydrochloric acid
77
76
73
72
74
71
81
80
First titanium dioxide particle doped with aluminum oxide
Hydrogen
Oxygen(Air )
Titanium tetrachloride
Aluminum trichloride

Fig. 5

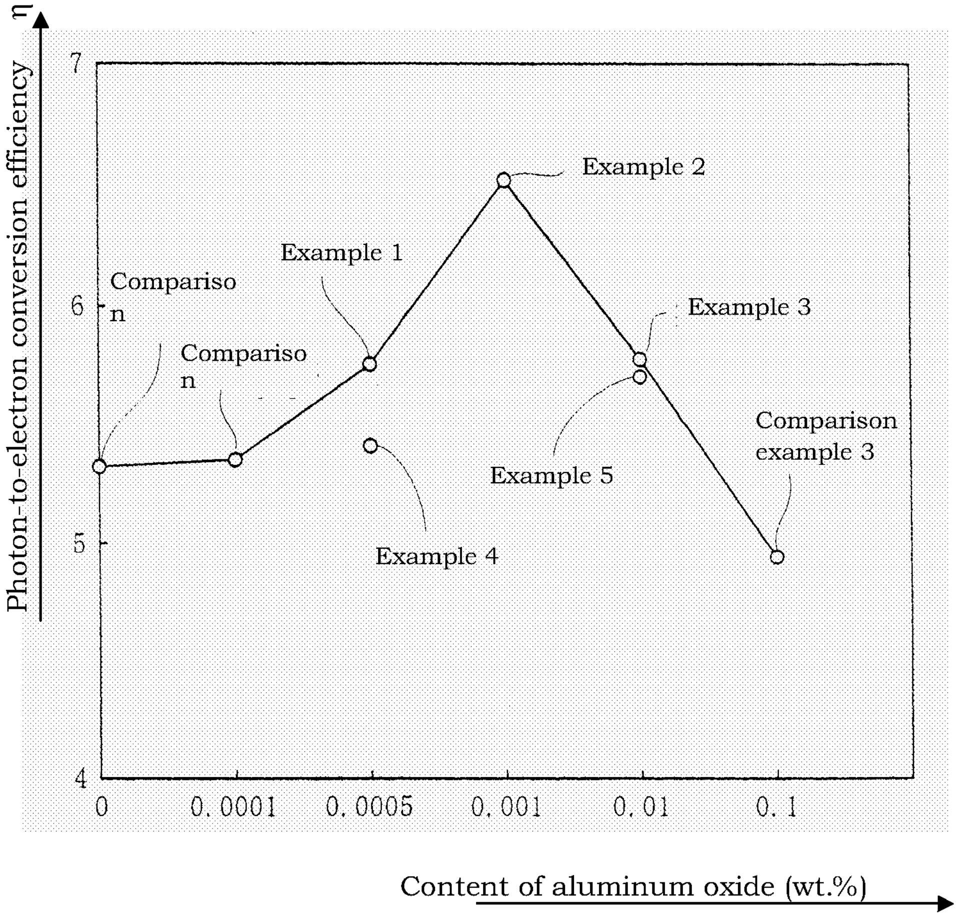
η
Photon-to-electron conversion efficiency
7
6
5
4
Example 2
Example 1
Comparison
Comparison
Example 3
Example 5
Comparison example 3
Example 4
0
0.0001
0.0005
0.001
0.01
0.1
Content of aluminum oxide (wt.%)

**INTERNATIONAL SEARCH REPORT**

International application No.
PCT/JP2005/016733

A. CLASSIFICATION OF SUBJECT MATTER
*H01M14/00*(2006.01), *C01G23/07*(2006.01), *H01L31/04*(2006.01)

According to International Patent Classification (IPC) or to both national classification and IPC

B. FIELDS SEARCHED

Minimum documentation searched (classification system followed by classification symbols)
*H01M14/00*(2006.01), *C01G23/07*(2006.01), *H01L31/04*(2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2003-168495 A (Catalysts & Chemicals Industries Co., Ltd.),<br>13 June, 2003 (13.06.03),<br>Claims 1 to 6; Par. Nos. [0052], [0124] to [0126]<br>& WO 03/37798 A1 & EP 1449811 A1<br>& US 2004/265587 A1 | 1,2,6,8<br>3-5,7 |
| X<br>A | JP 2002-280087 A (Toyota Central Research And Development Laboratories, Inc.),<br>27 September, 2002 (27.09.02),<br>Claims 1 to 7; Par. No. [0008]; examples<br>(Family: none) | 1,2,6,8<br>3-5,7 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>01 December, 2005 (01.12.05) | Date of mailing of the international search report<br>13 December, 2005 (13.12.05) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No. PCT/JP2005/016733

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2002-100418 A (Sumitomo Osaka Cement Co., Ltd.),<br>05 April, 2002 (05.04.02),<br>Claims 1 to 6; Par. No. [0035]; examples<br>(Family: none) | 1,6,8<br>2-5,7 |
| A | JP 5-504023 A (Graetzel, Michael),<br>24 June, 1993 (24.06.93),<br>Claims 1 to 10<br>& WO 91/16719 A2 & EP 525070 A1<br>& US 5350644 A | 1-8 |
| A | JP 2000-114563 A (Toshiba Corp.),<br>21 April, 2000 (21.04.00),<br>Claims 1 to 4; examples (example of Ta-Dope)<br>(Family: none) | 1-8 |
| A | JP 2002-258503 A (Ricoh Co., Ltd.),<br>11 September, 2002 (11.09.02),<br>Claims 1 to 12; examples (example of V-Dope)<br>(Family: none) | 1-8 |
| A | JP 10-505316 A (University of Cincinnati),<br>26 May, 1998 (26.05.98),<br>Claims 1 to 43; examples<br>& WO 96/6803 A1 & EP 778812 A1<br>& US 5698177 A | 7 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Journal of American Chemical Society,* 2003, vol. 2 (125), 475-482